(19) Europäisches Patentamt

European Patent Office

Office européen des brevets

(11) **EP 1 522 863 A1**

(12) **DEMANDE DE BREVET EUROPEEN**

(43) Date de publication:
**13.04.2005 Bulletin 2005/15**

(51) Int Cl.[7]: **G01R 31/06**, G01R 31/28

(21) Numéro de dépôt: **04104661.6**

(22) Date de dépôt: **24.09.2004**

(84) Etats contractants désignés:
**AT BE BG CH CY CZ DE DK EE ES FI FR GB GR HU IE IT LI LU MC NL PL PT RO SE SI SK TR**
Etats d'extension désignés:
**AL HR LT LV MK**

(30) Priorité: **03.10.2003 FR 0311640**

(71) Demandeur: **Areva T&D SA**
**92084 Paris-La Défense (FR)**
Etats contractants désignés:
**AT BE DE**

(72) Inventeur: **RYDER, Simon Andrew**
**75019, PARIS (FR)**

(74) Mandataire: **Poulin, Gérard et al**
**Société BREVATOME**
**3, rue du Docteur Lancereaux**
**75008 Paris (FR)**

(54) **Procédé pour diagnostiquer un défaut sur un enroulement de transformateur**

(57) La présente invention concerne un procédé pour diagnostiquer un défaut sur un enroulement de transformateur utilisant une analyse de réponse en fréquence ou FRA (Frequency Response Analysis en anglais). La présente invention est plus particulièrement adaptée aux transformateurs de puissance. Le procédé comporte les étapes suivantes:

- mesure de l'impédance dudit enroulement en fonction de la fréquence, ladite mesure étant représentée sous la forme d'un premier gain k en tension,
- comparaison de ladite mesure de l'impédance avec une mesure de référence représentée sous la forme d'un deuxième gain k' en tension.

Le procédé comporte en outre une étape de détermination de la variation relative de la première fréquence de résonance supérieure à 10 kHz, ladite variation relative étant obtenue en comparant lesdits premier et deuxième gains k et k'.

EP 1 522 863 A1

**Description**

La présente invention concerne un procédé pour diagnostiquer un défaut sur un enroulement de transformateur utilisant une analyse de réponse en fréquence ou FRA (Frequency Response Analysis en anglais). La présente invention est plus particulièrement adaptée aux transformateurs de puissance.

Les transformateurs de puissance (tels que des transformateurs ayant des tensions primaires de plusieurs centaines de kV et des puissances délivrées allant de quelques MVA à plusieurs centaines de MVA) sont des dispositifs extrêmement coûteux dans les systèmes d'interconnexion des réseaux de transmission. Il est donc très utile de pouvoir garder en service ces transformateurs le plus longtemps possible, une panne ou un défaut du transformateur pouvant avoir des conséquences économiques importantes dues à l'arrêt du réseau de distribution.

En outre, des défauts tels que des courts-circuits peuvent entraîner des risques d'explosion ou d'incendie.

Il est donc très important de pouvoir déterminer la présence de défaut lié à l'enroulement d'un transformateur.

Une solution connue à ce problème consiste à utiliser une analyse de réponse en fréquence appelée usuellement FRA (Frequency Response Analysis en anglais). Cette technique consiste à mesurer l'impédance d'un enroulement de transformateur sur une large gamme de fréquence et à comparer le résultat de ces mesures avec un ensemble de référence. Afin de mesurer l'impédance en fonction de la fréquence, on peut effectuer un balayage en fréquence en utilisant un signal sinusoïdal.

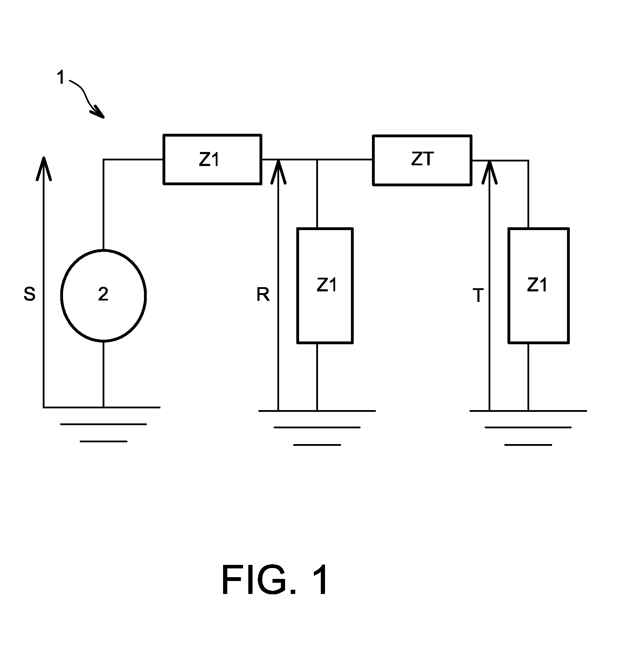

Ainsi, la figure 1 représente un schéma de principe d'un circuit 1 d'analyse en fréquence d'une impédance correspondant à l'impédance d'un enroulement de transformateur à mesurer.

Le circuit 1 comporte:

- un analyseur de réseau 2,
- trois impédances de test de même valeur Z1,
- une impédance ZT correspondant à l'impédance d'un enroulement de transformateur à mesurer.

L'analyseur de réseau 2 génère un signal S de mesure. Le signal S de mesure est un signal sinusoïdal balayé en fréquence. Les impédances Z1 sont par exemple les impédances des câbles de mesure et ont généralement une valeur égale à 50 Ohms. R est le signal mesuré entre la première extrémité de ZT et la masse. T est le signal mesuré entre la deuxième extrémité de ZT et la masse. L'analyseur 2 représente ensuite en fonction de la fréquence le gain en tension k défini par la relation suivante:

$$k=20\log_{10}\left(\frac{T}{R}\right).$$

Le gain k contient les informations nécessaires à l'étude de l'impedance ZT et vaut :

$$k=20\log_{10}\left(\frac{Z1}{Z1+ZT}\right).$$

Dans le cas d'une impédance Z1 égale à 50 Ohms, on a ainsi:

$$k=20\log_{10}\left(\frac{50}{50+ZT}\right).$$

L'impédance est mesurée sur une gamme très large de fréquence qui peut aller de quelques Hz à une dizaine de MHz.

La même mesure doit être effectuée sur un enroulement de référence. Cet enroulement de référence peut être soit une autre phase pour laquelle on fait l'hypothèse qu'il n'y a pas de défaut, soit le même enroulement sans défaut mesuré auparavant, soit l'enroulement d'un transformateur identique. On obtient donc également un gain k' en fonction de la fréquence correspondant à cet enroulement de référence.

Une première solution consiste alors à examiner à l'oeil les différences entre les courbes représentant k et k' en fonction de la fréquence.

Cette solution présente cependant certains problèmes.

En effet, l'examen à l'oeil effectué par un expert peut présenter une certaine subjectivité et manquer de transparence.

Une deuxième solution consiste à calculer des indicateurs statistiques permettant de mettre en évidence les différences entre les deux courbes. De tels indicateurs statistiques sont par exemple les coefficients de corrélation calculés dans différentes gammes de fréquences.

Toutefois, l'utilisation de ces indicateurs statistiques pose également certains problèmes.

Ainsi, certains défauts ne peuvent pas être identifiés; c'est le cas par exemple d'une mise à la terre du circuit magnétique du transformateur ou d'un courant de circulation entraînant un échauffement du transformateur.

De même, cette utilisation des indicateurs statistiques peut conduire à confondre certains défauts; par exemple, une mauvaise mise à la terre de la cuve du transformateur peut être confondue avec un endommagement de l'enroulement.

Une troisième solution est décrite dans le document «a new method for diagnosing transformer faults using frequency response analysis» (Simon Ryder, actes du colloque du comité A2 de CIGRE, Mérida (Mexico), 1-3 juin 2003, pages 123-135). Selon cette méthode, on calcule trois coefficients de corrélation $\rho_1$, $\rho_2$ et $\rho_3$ de k et k' sur les trois gammes de fréquences [1kHz-10kHz], [10kHz-100kHz] et [100kHz-1MHz] ainsi que les variations relatives du gain minimal déterminé pour une fréquence inférieure à 10kHz, de la fréquence de résonance fondamentale et du nombre de fréquences de résonance présentes dans un intervalle prédéterminé. Cette méthode présente l'avantage de permettre une augmentation du nombre de défauts détectables ainsi qu'une meilleure distinction des différents défauts entre eux.

Toutefois, la mise en oeuvre de cette troisième solution pose également quelques difficultés; ainsi, cette méthode ne permet notamment pas de faire la distinction entre un défaut lié à un déplacement axial de l'enroulement à analyser sans que ce dernier soit cependant trop endommagé localement et un défaut lié à un flambage d'un enroulement intérieur.

La présente invention vise à fournir un procédé pour diagnostiquer au moins un défaut sur un enroulement de transformateur et permettant de mieux distinguer les différents défauts entre eux.

La présente invention propose à cet effet un procédé pour diagnostiquer au moins un défaut sur un enroulement de transformateur comportant les étapes suivantes:

- mesure de l'impédance dudit enroulement en fonction de la fréquence, ladite mesure étant représentée sous la forme d'un premier gain en tension,
- comparaison de ladite mesure de l'impédance avec une mesure de référence représentée sous la forme d'un deuxième gain en tension, ledit procédé étant caractérisé en ce qu'il comporte une étape de détermination de la variation relative de la première fréquence de résonance supérieure à 10kHz, ladite variation relative étant obtenue en comparant lesdits premier et deuxième gains.

Grâce à l'invention, la détermination de la variation relative de la première fréquence de résonance supérieure à 10 kHz permet de faire la distinction entre un défaut lié à un déplacement axial de l'enroulement à analyser sans que ce dernier soit cependant trop endommagé localement et un défaut lié à un flambage d'un enroulement intérieur. Notons que, de façon générale, la détermination de la variation relative d'une fréquence de résonance se caclule comme suit:

$$VR_f = \frac{f}{f'}$$

où f désigne la première fréquence de résonance associée au premier gain et f' désigne la première fréquence de résonance associée au deuxième gain.

Avantageusement, le procédé comporte une étape de détermination de la variation relative de la dernière fréquence de résonance inférieure à 1 MHz.

Avantageusement, le procédé comporte une étape de détermination de la présence d'une fréquence de résonance inférieure à la fréquence de résonance fondamentale.

Avantageusement, le procédé comporte une étape de détermination de la variation absolue du gain maximal dans un intervalle prédéterminé.

Le gain maximal se définit comme la valeur maximale prise par le gain en tension k tel que décrit en référence à la figure 1 en fonction de la fréquence de mesure; à titre d'exemple, le gain maximal à déterminer est le gain maximal pour une fréquence qui peut être supérieure à 1 kHz. Il se peut en effet que le gain prenne une valeur maximale pour une fréquence inférieure à 1 kHz mais cette valeur est moins pertinente pour l'identification des défauts. On peut également fixer une borne supérieure pour le calcul du gain maximal qui peut être par exemple de l'ordre de 100 kHz. Notons de plus qu'il s'agit ici de calculer la variation absolue (et non relative) du gain maximal, variation que l'on peut définir comme suit:

$$VA_k = max(k) - max(k')$$

Selon ce dernier mode de réalisation, avantageusement, ledit intervalle prédéterminé est [1kHz; 100 kHz].

Avantageusement, le procédé comporte une étape de détermination de la variation relative d'une deuxième fréquence de résonance suivant la fréquence de résonance fondamentale.

Selon un mode de réalisation particulièrement avantageux, le procédé comporte les étapes suivantes:

- détermination de quatre coefficients de corrélation desdits premier et deuxième gains dans les quatre gammes de fréquence [100Hz, 1kHz], [1kHz-10kHz], [10kHz-100kHz] et [100kHz-1 MHz],
- détermination de la variation relative du gain minimal pour une fréquence inférieure à 10 kHz,
- détermination de la variation absolue du gain maximal dans un intervalle de fréquences prédéterminé,
- détermination de la variation relative de la fréquence de résonance fondamentale,
- détermination de la présence d'une deuxième fréquence de résonance suivant la fréquence de résonance fondamentale,
- détermination de la variation relative de ladite deuxième fréquence de résonance suivant la fréquence de résonance fondamentale,
- détermination de la présence d'une fréquence de résonance inférieure à la fréquence de résonance fondamentale,
- détermination de la variation relative de la dernière fréquence de résonance inférieure à 1 MHz,
- détermination de la variation relative du nombre de fréquences de résonance comprises entre dans un intervalle prédéterminé.

Avantageusement, ladite variation relative du nombre de fréquences de résonance se fait dans l'intervalle [100 kHz; 1 MHz].

Avantageusement, ladite détermination de la variation absolue du gain maximal se fait dans l'intervalle [1 kHz; 100 kHz].

Selon un mode de réalisation particulièrement avantageux, le procédé comporte les étapes suivantes:

- injection des résultats de chacune desdites détermination de variation relative et/ou de présence dans un système informatique expert,
- détermination et identification du ou des défauts par ledit système expert.

Un système expert est un programme d'ordinateur qui simule le comportement d'un expert humain. Pour cela, le système expert utilise des règles pour l'interprétation de données. Les avantages d'un système expert résident dans le fait que l'expertise est représentée d'une manière très facilement accessible au programmeur; en outre, un système expert a une structure uniforme basée sur des règles qui sont essentiellement autodocumentées. De plus, l'expertise est complètement séparée du traitement des données. Enfin, un système expert permet de traiter l'incertitude en prenant une décision basée sur une règle particulière et permet également de traiter un nombre considérable d'informations impossible à traiter rapidement par un expert humain.

Selon ce dernier mode de réalisation, avantageusement, le procédé comporte les étapes suivantes:

- attribution d'un facteur de certitude à chaque défaut susceptible d'être déterminé,
- détermination et identification du ou des défauts par ledit système expert sur la base d'une pluralité de règles modifiant lesdits facteurs de certitude en fonction desdits résultats de chacune desdites déterminations de variation relative et/ou de présence.

Avantageusement, la méthode de calcul de chaque facteur de certitude est basée sur les principes suivants:

Si CF'>0 et CF">0 alors :
CF=CF'+CF"(1-CF')
Si CF'=0
CF = CF"

Si CF' >0 et CF" <0 ou si CF' <0 et CF" >0

alors:

$$CF = \frac{CF'+CF''}{1-\min(|CF'|,|CF''|)}$$

Si CF'<0 et CF"<0 alors
CF=CF'+CF" (1+CF' )

où CF désigne la valeur courante du facteur de certitude, CF' désigne la valeur avant application d'une desdites règles et CF" désigne la valeur du facteur de certitude déterminée à partir d'une desdits règles et appliquée à CF'.

La présente invention a également pour objet un système informatique expert pour la mise en oeuvre du procédé selon l'invention caractérisé en ce qu'il comporte:

- une pluralité d'entrées adaptées pour recevoir les résultats de chacune desdites déterminations de variation relative et/ou des indicateurs de présence,
- une pluralité de sorties dites intermédiaires correspondant au nombre de défauts détectables, chaque sortie étant adaptée pour fournir un facteur de certitude calculé à partir de ladite pluralité de règles,
- une sortie dite finale adaptée pour produire un diagnostic du ou des défauts présents sur ledit enroulement de transformateur.

D'autres caractéristiques et avantages de la présente invention apparaîtront dans la description suivante d'un mode de réalisation de l'invention, donné à titre illustratif et nullement limitatif.

Dans les figures suivantes :

- la figure 1 représente schématiquement un circuit d'analyse de réponse en fréquence d'une impédance,
- la figure 2 représente schématiquement un transformateur triphasé,
- la figure 3 représente les gains respectifs en fonction de la fréquence de deux enroulements haute tension de deux phases d'un transformateur triphasé.

La figure 1 a déjà été décrite en relation avec l'état de la technique. Les mesures FRA présentées par la suite seront toujours réalisées à partir d'un circuit d'analyse tel que représenté en figure 1.

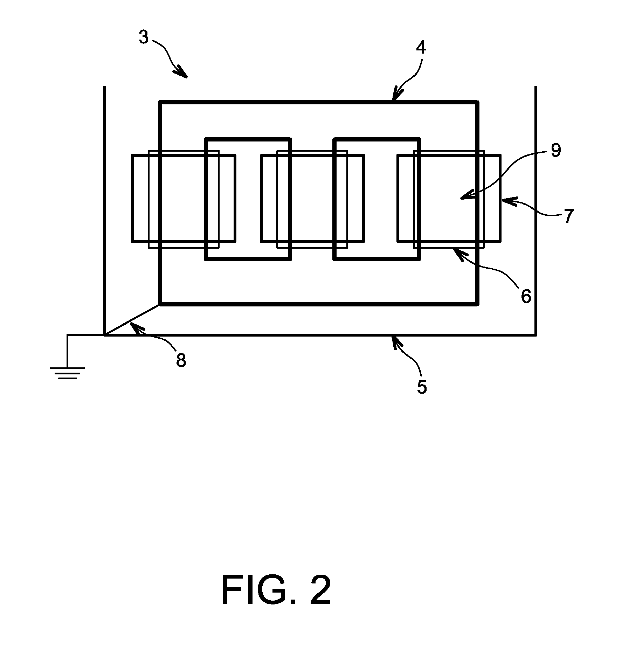

La figure 2 représente schématiquement un transformateur triphasé 3.

Le transformateur triphasé 3 comprend :

- un circuit magnétique 4,
- une cuve 5,
- trois enroulements basse tension 6,
- trois enroulements haute tension 7.

Chaque couple d'enroulement haute et basse tension correspond à une phase du transformateur associée à un noyau 9 du circuit 4. Les trois phases du transformateur seront respectivement notées par la suite A, B et C.

Le circuit magnétique 4 et la cuve 5 sont reliés par une liaison 8 et sont à la masse.

Trois mesures d'impédance peuvent être effectuées respectivement pour la haute et la basse tension.

Ainsi, si on suspecte un défaut sur l'un des enroulements haute tension du transformateur, on mesure le gain de cet enroulement en fonction de la fréquence, on effectue la même mesure pour un autre enroulement haute fréquence et on compare les gains respectifs de ces deux enroulements. Notons qu'une troisième mesure est également possible en utilisant le troisième enroulement haute fréquence.

Notons que l'on peut également effectuer une comparaison entre les mesures sur l'enroulement soupçonné et des mesures réalisées antérieurement sur le même enroulement. On peut aussi faire une comparaison entre les mesures sur l'enroulement soupçonné et un enroulement équivalent d'un autre transformateur de la même conception.

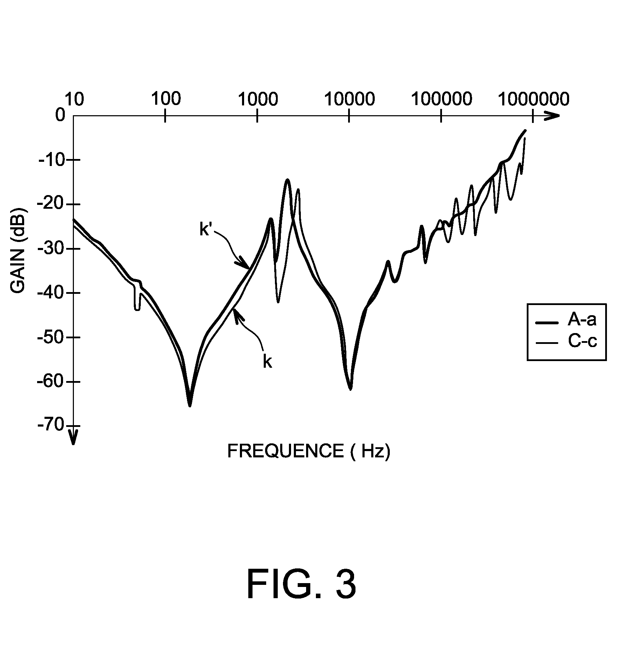

A titre d'exemple, la figure 3 représente les gains k et k' respectifs de deux enroulements haute tension des phases respectives C et A d'un transformateur triphasé tel que celui représenté en figure 2.

Les gains k et k' sont représentés pour une fréquence variant de 10 Hz à 1 MHz.

Afin de déterminer la présence d'un éventuel défaut et de diagnostiquer ce dernier, le procédé selon l'invention comporte la détermination des onze paramètres suivants :

Les quatre premiers paramètres sont les coefficients de corrélation $\rho_1$, $\rho_2$, $\rho_3$ et $\rho_4$ de k et k' calculés sur les trois gammes de fréquences [100Hz, 1kHz], [1kHz-10kHz], [10kHz-100kHz] et [100kHz-lMHz].

Rappelons que le coefficient de corrélation ρ pour deux ensembles de n nombres $X\{x_1, x_2, ..., x_n\}$ et $Y\{y_1, y_2, ..., y_n\}$ est défini par la relation :

$$\rho = \sum_{x=i}^{n} x_i y_i \left/ \sqrt{\sum_{i=1}^{n} x_i^2 \sum_{i=1}^{n} y_i^2} \right. .$$

Le cinquième paramètre est défini comme la variation relative $VR_{f1}$ de la fréquence de résonance fondamentale. La fréquence de résonance fondamentale est la première fréquence de résonance de chacun des gains k et k'. Si on appelle f1 et f1' les fréquences de résonance fondamentales respectives des gains k et k', le paramètre $VR_{f1}$ est défini par la relation:

$$VR_{f1} = \frac{f1}{f1'}$$

Le sixième paramètre est défini comme la variation relative $VR_{f2}$ de la deuxième fréquence de résonance immédiatement après la fréquence de résonance fondamentale. Le paramètre $VR_{f2}$ est défini par la relation :

$$VR_{f2} = \frac{f2}{f2'}$$

, où f2 et f2' désignent les deuxièmes fréquences de résonance respectives de k et k' .

Le septième paramètre est défini comme la variation relative $VR_{f3}$ de la première fréquence de résonance supérieure à 10 kHz. Le paramètre $VR_{f3}$ est défini par la relation: $VR_{f3} = \frac{f3}{f3'}$, où f3 et f3' désignent respectivement les premières fréquences de résonance supérieures à 10 kHz de k et k'.

Le huitième paramètre est défini comme la variation relative $VR_{f4}$ de la dernière fréquence de résonance inférieure à 1 MHz. Le paramètre $VR_{f4}$ est défini par la relation : $VR_{f4} = \frac{f4}{f4'}$, où f4 et f4' désignent respectivement les dernières fréquences de résonance inférieures à 1 MHz de k et k'.

Le neuvième paramètre est défini comme la variation relative du gain minimal $VR_{k1}$ en basse fréquence, c'est à dire à une valeur de fréquence inférieure à 10 kHz. Ainsi, si on appelle k1 le gain minimal de l'impédance à analyser et k1' le gain minimal de l'impédance de référence, le paramètre $VR_{k1}$ est défini par la relation:

$$VR_{k1} = \frac{k1}{k1'}.$$

Le dixième paramètre est défini comme la variation absolue $VA_{k2}$ du gain maximum pour une fréquence comprise entre 1 kHz et 100 kHz. Ainsi, si on appelle k2 le gain maximal de l'impédance à analyser et k2' le gain maximal de l'impédance de référence, le paramètre $VA_{k2}$ est défini par la relation :

$$VA_{k2} = k2 - k2'$$

Le onzième paramètre est défini comme la variation relative $VR_n$ du nombre de fréquences de résonance comprises entre 100 kHz et 1 MHz. Le paramètre $VR_n$ est défini par la relation : $VR_n = \frac{n}{n'}$ où n et n' désignent respectivement le nombre de fréquences de résonance supérieures de k et k' dans l'intervalle [100kHz-1 MHz].

Le procédé selon l'invention comporte également la détermination de la présence d'une fréquence de résonance de type rebond (blip en anglais), c'est à dire une fréquence de résonance inférieure à la fréquence de résonance fondamentale et de faible amplitude. La présence d'une fréquence de type rebond se traduit par un indicateur logique prenant deux valeurs selon que la fréquence est ou non présente.

Le procédé selon l'invention comporte également la détermination de la présence d'une deuxième fréquence de résonance suivant la fréquence de résonance fondamentale. La présence d'une telle deuxième fréquence de résonance se traduit par un indicateur logique prenant deux valeurs selon que la fréquence est ou non présente.

L'ensemble des onze paramètres accompagnés des indicateurs de présence d'une fréquence de rebond et d'une deuxième fréquence de résonance sont injectés dans un système expert caractérisé par une pluralité de facteurs de certitude Ci. Le nombre de facteur de certitudes correspond au nombre de fautes susceptibles d'être détectées par le système expert. Les quatorze types de fautes détectables ainsi que leurs facteurs de certitude associés sont résumés dans le tableau 1 ci-dessous.

Tableau 1

| Types de fautes | Facteurs de certitudes |
|---|---|
| 1) Mauvaise mise à la terre de la cuve (haute résistance)/absence de mise à la terre de la cuve | C1 |
| 2) Absence de mise à la terre du circuit magnétique | C2 |
| 3) Boucle fermée mise à la terre/boucle fermée mise à un potentiel flottant | C3 |
| 4) Spire additionnelle en court-circuit (même phase) | C4 |
| 5) Défaut entre bornes de l'enroulement (enroulement analysé affecté) | C5 |
| 6) Défaut entre bornes de l'enroulement (autre enroulement d'une même phase affecté) | C6 |
| 7) Une spire en court-circuit | C7 |
| 8) Plusieurs spires en court-circuit | C8 |
| 9) Court-circuit sur la seule phase adjacente | C9 |
| 10) Court-circuit sur une autre phase que sur la seule phase adjacente | C10 |
| 11) Enroulement déplacé | C11 |
| 12) Flambage de l'enroulement intérieur | C12 |
| 13) Enroulement endommagé | C13 |
| 14) Mauvaise continuité | C14 |

L'explication suivante des défauts sera faite en référence à la figure 2.

Le défaut 1 correspond à une mauvaise mise à la terre de la cuve 5; il peut s'agir d'une absence de mise à la terre ou d'une mise à la terre avec une résistance élevée entre la cuve 5 et la terre (supérieure à 50 Ohms).

Le défaut 2 correspond à une absence de mise à la terre du circuit magnétique 4, c'est à dire à une rupture de la liaison 8.

Le défaut 3 correspond à une boucle de courant de circulation mis soit à la terre soit à un potentiel flottant; ces boucles entraînent un échauffement du transformateur.

Le défaut 4 correspond à la présence d'une spire additionnelle créant un court-circuit sur la phase à laquelle appartient l'enroulement à analyser.

Le défaut 5 correspond à un défaut entre les bornes de l'enroulement à analyser, c'est à dire un court-circuit de l'enroulement entier.

Le défaut 6 correspond à un défaut entre les bornes d'un enroulement appartenant à la même phase que l'enroulement à analyser.

Le défaut 7 correspond à un court-circuit présent sur une spire des enroulements appartenant à la même phase que l'enroulement à analyser. Ce défaut produit un échauffement du transformateur.

Le défaut 8 correspond à un court-circuit présent sur plusieurs spires appartenant à la même phase que l'enroulement à analyser. Ce défaut produit un échauffement du transformateur.

Le défaut 9 correspond à un défaut de court-circuit tel qu'un court-circuit entre spires, entre bornes ou sur une spire additionnelle. Il indique que le défaut se trouve sur une phase à côté de celle où la mesure a été effectuée et que la phase où se trouve le défaut est la seule phase adjacente, c'est à dire immédiatement à côté de la phase où la mesure a été effectuée. Ainsi, si le défaut se trouve sur le noyau central, l'analyse des autres phases produira ce code car la phase centrale est bien la seule phase immédiatement à côté des phases de gauche et de droite.

Le défaut 10 correspond également à un défaut de court-circuit tel qu'un court-circuit entre spires, entre bornes ou sur une spire additionnelle. Il indique cependant que le défaut n'est pas sur une phase unique se trouvant immédiatement à côté de la phase où la mesure a été effectuée. Ainsi, si le défaut se trouve sur le noyau de gauche, l'analyse de la phase centrale produira ce code car il y a bien deux phases immédiatement à côté de la phase centrale et non une seule.

Le défaut 11 correspond à un déplacement axial de l'enroulement à analyser sans que ce dernier soit cependant trop endommagé localement.

Le défaut 12 correspond à un flambage d'un enroulement intérieur.

Le défaut 13 correspond à un endommagement mécanique local sur l'enroulement à analyser.

Le défaut 14 correspond à une mauvaise continuité électrique dans l'enroulement à analyser. Cette mauvaise continuité peut être liée à un mauvais contact de mesure.

Comme décrit plus haut, on associe chaque défaut de type i à un facteur de certitude Ci du système expert.

Chaque facteur de certitude Ci est une variable qui peut prendre une valeur réelle comprise entre 1 (certitude du défaut) et -1 (défaut impossible). Chaque facteur de certitude est initialisé à 0.

Appelons Ci' le facteur de certitude associé au défaut i avant l'application d'une règle; soit Ci'' le facteur de certitude associé à ce même défaut i et déterminé par ladite règle; soit Ci le facteur de certitude courant à calculer. Ce facteur de certitude Ci sera par exemple déterminé selon les principes suivants:

Si Ci'>0 et Ci''> 0 alors:

$$Ci = Ci' + Ci''(1-Ci')$$

Si Ci'=0
Ci=Ci''
Si Ci'>0 et Ci'' <0 ou si Ci' <0 et Ci''> 0 alors:

$$Ci = \frac{Ci' + Ci''}{1 - \min(|Ci'|, |Ci''|)}$$

Si Ci'<0 et Ci'' <0 alors:

$$Ci = Ci' + Ci''(1 + Ci').$$

Prenons l'exemple suivant: Ci'=0,5 et Ci''=0,5 vont donner un facteur de certitude Ci égal à 0,75.

Ce facteur de certitude Ci égal à 0,75 devient donc le nouveau facteur de certitude Ci'. Si il est nouvellement combiné avec un facteur de certitude Ci'' égal à 0,5, le facteur de certitude devient 0,875.

Si le facteur de certitude égal à 0,75 est au contraire nouvellement combiné avec un facteur de certitude Ci'' égal à -0,5 et non 0,5, le facteur de certitude devient 0,5 et non 0,875.

Notons que la combinaison de n'importe quel facteur de certitude, autre que -1, avec 1 donnera un nouveau facteur de certitude égal à 1.

Notons également que la combinaison de n'importe quel facteur de certitude, autre que 1, avec -1 donnera un facteur de certitude égal à -1.

Notons enfin que la combinaison de 1 avec -1 donne une valeur indéfinie.

Les règles appliquées par le système expert fixent une valeur de Ci'' selon que certaines conditions sur les paramètres sont vérifiées. Les règles appliquées par le système expert sont par exemple les suivantes:

```
/*règle 1*/
      si (ρ₁<0.25)
      alors (C4'' ) {0.5} [c'est à dire qu'on combine 0.5 et la valeur existante de C4' en utilisant les principes décrits
plus haut]
      (C8'') {10.5}
      (C7'') {-0.5}
      (C5'') {0.25}
      (C6'') {0.25}


/*règle 2*/
      si (ρ₂< normal)
      alors (C8'') {0.25}
      (C7'') {-0.25}
      (C5'') {0.25}
      (C6'') {0.25}


/*règle 3*/
      si ((ρ₂ < normal) et (ρ₂> 0.5) )
```

alors (C4") {0.5}

/*règle 4*/
    si (($\rho_2$ < normal) et ($\rho_2$> 0.7))
    alors (C9") {0.1}
    (C10") {0.1}
    (C11") {0.25}
    (C12") {0.25}

/*règle 5*/
    si ($\rho_3$ < normal)
    alors (C5") {0.5}

/*règle 6*/
    si ( ($\rho_3$ < normal) et ($\rho_3$> 0.7))
    alors (C11") {0.5}
    (C12") {0.5}

/*règle 7*/
    si ( ($\rho_3$ < normal) et ($\rho_3$> 0.9))
    alors (C8") {0.1}

/*règle 8*/
    si ($\rho_4$< normal)
    alors (C5") {0.25}
    (C6") {-0.7}

/*règle 9*/
    si ( ($\rho_4$ < normal) et ($\rho_4$ > 0.7))
    alors (C1") {0.5}
    (C11") {0.25}
    (C12") {0.25}
    (C13") {0.5}

/*règle 10*/
    si ( ($\rho_4$ < normal) et ($\rho_4.$> 0.9))
    alors (C3") {0.1}
    (C8") {0.1}

/*règle 11*/
    si (présence fréquence de rebond)
    alors (C4") {0.5}
    (C8") {-0.5}
    (C5") {-0.7}
    (C6") {-0.7}

/*règle 12*/
    si (absence de fréquence de rebond)
    alors (C4") {-0.25}

/*règle 13*/
    si (VR$_{f1}$<0.75)
    alors (C5") {0.5}
    (C6") {0.5}

/*règle 14*/
    si ( (VR$_{f1}$ <0. 9) et (VR$_{f1}$ > 0.75))
    alors (C2") {0.25}

(C3") {0.5}

/*règle 15a*/
    si (VR$_{f1}$ <0.9)
    alors (C4") {-1}
    (C7") {-1}
    (C10") {-1}

/*règle 15b*/
    si (VR$_{f1}$ <1.1)
    alors (C4") {-0.5}
    (C8") {-1}
    (C9") {-1}

/*règle 16*/
    si ( (VR$_{f1}$<1.25) et (VR$_{f1}$>1.1) )
    alors (C7") {0.5}
    (C10") {0.5}

/*règle 17*/
    si ( (VR$_{f1}$<1 .5) et (VR$_{f1}$>1.25) )
    alors (C9") {0.5}

/*règle 18*/
    si (VR$_{f1}$>1.5)
    alors (C8") {0.5}

/*règle 19*/
    si ((VR$_{f1}$ <5) et (VR$_{f1}$>1.5))
    alors (C4") {0.5}

/*règle 20*/
    si (VR$_{f1}$>5)
    alors (C4" ) {-0.25}

/*règle21*/
    si (absence de seconde fréquence de résonance)
    alors (C4"){0.25}
    (C8") {0.25}
    (C7") {0.25}
    (C9") {0.25}
    (C10") {0.25}

/règle 22*/
    si (présence d'une seconde fréquence de résonance)
    alors (C4" ) {-1}
    (C8") {-1}
    (C7") {-1}
    (C9") {-1}
    (C10") {-1}

/*règle 23*/
    si ((VR$_{f2}$<0.9) et (VR$_{f2}$> 0.75))
    alors (C2") {0.25}
    (C3") {0.5}

/*règle 24*/
    si (VR$_{f3}$ <0.95)

```
        alors (C11") {-0.5}
        (C12") {0.5}


/*règle 25*/
        si (VR_{f3}>1.05)
        alors (C11') {0.5}
        (C12" ) {-0.5}


/*règle 26*/
        si ( (VR_{f3} <1.05) et (VR_{f3}>0. 95) )
        alors (C11") {-0.5}
        (C12" ) {-0.5}


/*règle 27*/
        si ((VR_{f4}<0.9) ou (VR_{f4}>1.1))
        alors (C1") {0.25}
        (C13") {0.25}


/*règle 28*/
        si(VR_{f4}<0.9)
        alors (C11"){-0.25}
        (C12") {0.25}


/*règle 29*/
        si (VR_{f4}>1.1)
        alors (C11") {0.25}
        (C12") {-0.25}


/*règle 30*/
        si (VR_n <1)
        alors (C13") {-0.5}


/*règle 31*/
        si ((VR_n <1.2) et(VR_n>1.1))
        alors (C13") {0.25}


/*règle 32*/
        si (VR_n>1.2)
        alors (C13") {0.5}


/*règle 33a*/
        si (VR_{k1} > normal)
        alors (C2") {-0.25}
        (C4") {-1}
        (C8") {-1}
        (C7") {-0.5}
        (C5") {-1}
        (C6") {-1}


/*règle 33b*/
        si (VR_{k1} = normal)
        alors (C4") {-0.5}
        (C8") {-0.5}
        (C5") {-1}
        (C6") {-1}


/*règle 34*/
        si ( (VR_{k1} <normal) et (VR_{k1} > 0.8))
```

```
        alors (C2") {0.25}


/*règle 35*/
        si ( (VR_{k1} <normal) et (VR_{k1} > 0.35))
        alors (C7") {0.5}


/*règle 36*/
        si ( ( (VR_{k1} <normal) ou (VR_{k1}<0.85)) et (VR_{k1}>0.15))
        alors (C4") {0.5}
        (C8") {0.5}


/*règle 37*/
        si (VR_{k1} <0.15)
        alors (C5") {0.5}
        (C6") {0.5}


/*règle 38*/
        si (VR_{k2} <-3)
        alors (C14") {1}
```

On entend par le terme "normal" dans ce qui précède des variations possibles dans des circonstances normales d'utilisation. Les plages de variation du type « normal » peuvent être ajustées par l'utilisateur.

On peut par exemple utiliser les variations normales données dans le tableau 2 suivant pour un même enroulement:

Tableau 2

| Paramètre | Variation normale |
|---|---|
| p2 | 0,995 |
| p3 | 0,995 |
| p4 | 0,995 |
| $VR_{k1}$ (voir ci-dessous) | +/-3 dBm |

Il faut estimer la variation normale de la variation relative du gain minimal en basse fréquence, en fonction de sa valeur dans la mesure de référence et la variation normale en valeur absolue. Si le gain minimal dans la mesure de référence est de -100dBm, la gamme de variation normale est de 0.94 à 1.06. Si le gain minimal dans la mesure de base est de -30dBm, la gamme de variation normale est de 0.80 à 1.20.

Le système expert comporte

- treize entrées correspondant aux onze paramètres et aux deux indicateurs de présence,
- quatorze sorties intermédiaires correspondant chacune à un type de faute,
- une sortie finale diagnostiquant le ou les types de fautes.

Après que toutes les règles aient été appliquées, chacune des 14 sorties intermédiaires (correspondant à un type de faute) du système expert va être associée à un facteur de certitude Ci (i variant de 1 à 14).

Le diagnostic final se fait en appliquant les principes suivants:

- si aucune sortie intermédiaire n'a un facteur de certitude supérieur à 0, le diagnostic correspond à une absence de défaut,
- si une ou plusieurs sorties intermédiaires ont un facteur de certitude supérieur à 0 et si une sortie intermédiaire a un facteur de certitude supérieur aux autres, le diagnostic correspond à la présence d'un défaut associé à cette dernière sortie intermédiaire,
- si deux (ou plus) sorties ont un facteur de certitude supérieur à 0 et si deux sorties ont un même facteur de certitude supérieur aux autres, le diagnostic correspond à la présence des deux défauts associés aux sorties précédemment citées à moins qu'une des exceptions ci-dessous ne se produise:

° si les deux défauts sont respectivement des défauts de type 4 et de type 8, le diagnostic correspond à la présence d'un défaut de type 4 ou de type 8,
° si les deux défauts sont respectivement des défauts de type 5 et de type 6, le diagnostic correspond à la présence d'un défaut de type 6,
° si les deux défauts sont respectivement des défauts de type 11 et de type 12, le diagnostic correspond à la présence d'un défaut de type 11 ou de type 12,
° si les deux défauts sont respectivement des défauts de type 1 et de type 13, le diagnostic correspond à la présence d'un défaut de type 1,
° si les deux défauts sont respectivement des défauts de type 8 et de type 9 (ou de type 10), le diagnostic correspond à la présence d'un défaut de type 8,

- si trois (ou plus) sorties ont un facteur de certitude supérieur à 0 et si trois (ou plus) sorties ont un même facteur de certitude supérieur aux autres, le diagnostic correspond à un défaut non identifié.

Bien entendu, l'invention n'est pas limitée au mode de réalisation qui vient d'être décrit.
Notamment, le système expert peut utiliser d'autres règles que celles décrites plus haut uniquement à titre d'exemple.

## Revendications

1. Procédé pour diagnostiquer au moins un défaut sur un enroulement de transformateur comportant les étapes suivantes:

   - mesure de l'impédance dudit enroulement en fonction de la fréquence, ladite mesure étant représentée sous la forme d'un premier gain (k) en tension,
   - comparaison de ladite mesure de l'impédance avec une mesure de référence représentée sous la forme d'un deuxième gain (k') en tension,

   ledit procédé étant **caractérisé en ce qu'**il comporte une étape de détermination de la variation relative de la première fréquence de résonance supérieure à 10 kHz, ladite variation relative étant obtenue en comparant lesdits premier et deuxième gains (k, k').

2. Procédé selon la revendication 1, **caractérisé en ce qu'**il comporte une étape de détermination de la variation relative de la dernière fréquence de résonance inférieure à 1 MHz.

3. Procédé selon l'une des revendications 1 ou 2, **caractérisé en ce qu'**il comporte une étape de détermination de la présence d'une fréquence de résonance inférieure à la fréquence de résonance fondamentale.

4. Procédé selon l'une des revendications 1 à 3, **caractérisé en ce qu'**il comporte une étape de détermination de la variation absolue du gain maximal dans un intervalle prédéterminé.

5. Procédé selon la revendication précédente, **caractérisé en ce que** ledit intervalle prédéterminé est [1 kHz; 100 kHz].

6. Procédé selon l'une des revendications précédentes, **caractérisé en ce qu'**il comporte une étape de détermination de la variation relative d'une deuxième fréquence de résonance suivant la fréquence de résonance fondamentale.

7. Procédé selon l'une des revendications précédentes, **caractérisé en ce qu'**il comporte les étapes suivantes :

   - détermination de quatre coefficients de corrélation ($\rho_1$, $\rho_2$, $\rho_3$, $\rho_4$) desdits premier et deuxième gains (k, k') dans les quatre gammes de fréquence [100Hz, 1kHz], [1kHz-10kHz], [10kHz-100kHz] et [100kHz-1MHz],
   - détermination de la variation relative du gain minimal pour une fréquence inférieure à 10 kHz,
   - détermination de la variation absolue du gain maximal dans un intervalle de fréquences prédéterminé,
   - détermination de la variation relative de la fréquence de résonance fondamentale,
   - détermination de la présence d'une deuxième fréquence de résonance suivant la fréquence de résonance fondamentale,
   - détermination de la variation relative de ladite deuxième fréquence de résonance suivant la fréquence de résonance fondamentale,
- détermination de la présence d'une fréquence de résonance inférieure à la fréquence de résonance fondamentale,
- détermination de la variation relative de la dernière fréquence de résonance inférieure à 1 MHz,
- détermination de la variation relative du nombre de fréquences de résonance comprises dans un intervalle prédéterminé.

8. Procédé selon la revendication précédente, **caractérisé en ce que** ladite variation relative du nombre de fréquences de résonance se fait dans l'intervalle [100 kHz; 1 MHz].

9. Procédé selon l'une des revendications 7 ou 8, **caractérisé en ce que** ladite détermination de la variation absolue du gain maximal se fait dans l'intervalle [1 kHz ; 100 kHz].

10. Procédé selon l'une des revendications précédentes **caractérisé en ce qu'**il comporte les étapes suivantes:

- injection des résultats de chacune desdites détermination de variation relative et/ou de présence dans un système informatique expert,
- détermination et identification du ou des défauts par ledit système expert.

11. Procédé selon la revendication précédente, **caractérisé en ce qu'**il comporte les étapes suivantes:

- attribution d'un facteur de certitude à chaque défaut susceptible d'être déterminé,
- détermination et identification du ou des défauts par ledit système expert sur la base d'une pluralité de règles modifiant lesdits facteurs de certitude en fonction desdits résultats de chacune desdites détermination de variation relative et/ou de présence.

12. Procédé selon la revendication précédente **caractérisé en ce que** la méthode de calcul de chaque facteur de certitude est basée sur les principes suivants:

Si CF' >0 et CF" >0 alors :

$$CF = CF' + CF''(1-CF')$$

Si CF'=0
CF=CF"
Si CF'>0 et CF"<0 ou si CF'<0 et CF">0 alors :

$$CF = \frac{CF' + CF''}{1 - \min(|CF'|, |CF''|)}$$

Si CF' <0 et CF"<0 alors :

$$CF = CF' + CF''(1+CF')$$

où CF désigne la valeur courante du facteur de certitude, CF' désigne la valeur avant application d'une desdites règles et CF" désigne la valeur du facteur de certitude déterminée à partir d'une desdites règles et appliquée à CF'.

13. Système informatique expert pour la mise en oeuvre du procédé selon l'une des revendications 11 ou 12 **caractérisé en ce qu'**il comporte:

- une pluralité d'entrées adaptées pour recevoir les résultats de chacune desdites déterminations de variation relative et/ou des indicateurs de présence,
- une pluralité de sorties dites intermédiaires correspondant au nombre de défauts détectables, chaque sortie étant adaptée pour fournir un facteur de certitude calculé à partir de ladite pluralité de règles,
- une sortie dite finale adaptée pour produire un diagnostic du ou des défauts présents sur ledit enroulement

de transformateur.

FIG. 1

FIG. 2

**FIG. 3**

**Office européen des brevets**

**RAPPORT DE RECHERCHE EUROPEENNE**

Numéro de la demande

EP 04 10 4661

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | C.SWEETSER , T. MCGRAIL: "SWEEP FREQUENCY RESPONSE ANALYSIS TRANSFORMER APPLICATIONS"[Online] 27 janvier 2003 (2003-01-27), XP002287739 Extrait de l'Internet: URL:www.doble.com/pdf/sfra_t.pdf> [extrait le 2004-07-02] | 1-6,10 | G01R31/06 G01R31/28 |
| Y | * page 44, ligne 1 - page 46, ligne 12; figures 30-35 * * page 16, ligne 1 - ligne 28; figure 8 * | 7-9, 11-13 | |
| A | | 12 | |
| | ----- | | |
| X | VANAJA R ET AL: "FAULT LOCATION IN POWER TRANSFORMERS DURING IMPULSE TESTS" 2000 IEEE POWER ENGINEERING SOCIETY. WINTER MEETING. CONFERENCE PROCEEDINGS. SINGAPORE, JAN. 23-27, 2000, IEEE POWER ENGINEERING SOCIETY WINTER MEETING, NEW YORK, NY : IEEE, US, vol. VOL. 3 OF 4, 23 janvier 2000 (2000-01-23), pages 2199-2204, XP000967811 ISBN: 0-7803-5936-4 * page 2201, colonne 2, ligne 39 - ligne 61 * | 1 | |
| | ----- -/-- | | |

**DOMAINES TECHNIQUES RECHERCHES (Int.Cl.7)**

G01R

Le présent rapport a été établi pour toutes les revendications

| Lieu de la recherche | Date d'achèvement de la recherche | Examinateur |
|---|---|---|
| La Haye | 17 février 2005 | Koll, H |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**Office européen des brevets**

**RAPPORT DE RECHERCHE EUROPEENNE**

Numéro de la demande

EP 04 10 4661

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| D,Y | RYDER S A ED - INSTITUTE OF ELECTRICAL AND ELECTRONICS ENGINEERS: "METHODS FOR COMPARING FREQUENCY RESPONSE ANALYSIS MEASUREMENTS" CONFERENCE RECORD OF THE 2002 IEEE INTERNATIONAL SYMPOSIUM ON ELECTRICAL INSULATION. (ISEI 2002). BOSTON, MA, APRIL 7 - 10, 2002, INTERNATIONAL SYMPOSIUM ON ELECTRICAL INSULATION, NEW YORK, NY : IEEE, US, 7 avril 2002 (2002-04-07), pages 187-190, XP001162794 ISBN: 0-7803-7337-5 * le document en entier * ----- | 7-9 | |
| Y | US 5 214 653 A (SCHNEIDER MORDECHAY ET AL) 25 mai 1993 (1993-05-25) * colonne 5, ligne 24 - colonne 6, ligne 42; figure 5 * ----- | 11-13 | |
| A | M5100 SEEP FREQUENCY RESPONSE ANALYZER, [Online] juin 2001 (2001-06), XP002287740 Extrait de l'Internet: URL:WWW.DOBLE.COM/PDF/M5100%20SPEC%20SHEET .PDF> [extrait le 2004-07-08] * le document en entier * ----- | 10-13 | DOMAINES TECHNIQUES RECHERCHES (Int.Cl.7) |
| A | J.C. LARSSON: "AN EXPERT SYSTEM FOR FREQUENCY RESONSE ANALYSIS" IEEE, 1994, pages 52-57, XP002287741 * abrégé * ----- -/-- | 10-13 | |

Le présent rapport a été établi pour toutes les revendications

| Lieu de la recherche | Date d'achèvement de la recherche | Examinateur |
|---|---|---|
| La Haye | 17 février 2005 | Koll, H |

EPO FORM 1503 03.82 (P04C02)

**EP 1 522 863 A1**

**Office européen des brevets**

**RAPPORT DE RECHERCHE EUROPEENNE**

Numéro de la demande

EP 04 10 4661

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | PLEITE J ET AL: "Transformer modeling for FRA techniques" IEEE/PES TRANSMISSION AND DISTRIBUTION CONFERENCE AND EXHIBITION 2002 : ASIA PACIFIC. YOKOHAMA, JAPAN, OCT. 6 - 10, 2002, IEEE/PES TRANSMISSION AND DISTRIBUTION CONFERENCE AND EXPOSITION, NEW YORK, NY : IEEE, US, vol. VOL. 1 F 3, 6 octobre 2002 (2002-10-06), pages 317-321, XP010631412 ISBN: 0-7803-7525-4 * page 320, colonne 2, ligne 12 - page 321, colonne 1, ligne 3; figures 4,8,9 * ----- | 1 | |
| A | LIU XIAOWEI ET AL: "Test research on power transformer winding deformation by FRA method" CONFERENCE PROCEEDINGS ARTICLE, 19 novembre 2001 (2001-11-19), pages 837-840, XP010570041 * page 838, colonne 1, ligne 10 - colonne 2, ligne 14 * ----- | 1-9 | DOMAINES TECHNIQUES RECHERCHES (Int.Cl.7) |

Le présent rapport a été établi pour toutes les revendications

| Lieu de la recherche | Date d'achèvement de la recherche | Examinateur |
|---|---|---|
| La Haye | 17 février 2005 | Koll, H |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.......................................................................................................
& : membre de la même famille, document correspondant

EPO FORM 1503 03.82 (P04C02)

21

**ANNEXE AU RAPPORT DE RECHERCHE EUROPEENNE
RELATIF A LA DEMANDE DE BREVET EUROPEEN NO.**                    EP 04 10 4661

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

17-02-2005

| Document brevet cité au rapport de recherche | Date de publication | Membre(s) de la famille de brevet(s) | Date de publication |
|---|---|---|---|
| US 5214653          A | 25-05-1993 | AUCUN | |

EPO FORM P0460